Europäisches Patentamt

European Patent Office

Office européen des brevets

(19)

(11) Veroffentlichungsnummer **0 006 475**
**B1**

(12) **EUROPÄISCHE PATENTSCHRIFT**

(45) Veroffentlichungstag der Patentschrift
20.05.81

(21) Anmeldenummer 79101708.0

(22) Anmeldetag 01.06.79

(51) Int Cl³ **C 23 C 15/00, H 01 J 37/34**

54 Vorrichtung zur Beschichtung von Werkstücken durch Kathodenzerstäuben.

30 Priorität 26.06.78 US 919337

13 Veröffentlichungstag der Anmeldung
09 01 80 Patentblatt 80/1

45 Bekanntmachung des Hinweises auf die Patenterteilung
20.05 81 Patentblatt 81/20

84 Benannte Vertragsstaaten
**DE FR GB**

56 Entgegenhaltungen
**DE-A-1 952 626**
**DE-A-2 026 321**
**US-A-3 423 303**
**IBM TECHNICAL DISCLOSURE BULLETIN,**
**Vol. 12, Nr. 11, April 1970,**
**New York, US,**
**M. S. FINK: »Substrate transport during sputter**
**deposition«,**
**Seite 1854**
**IBM TECHNICAL DISCLOSURE BULLETIN,**
**Vol. 19, Nr. 2, Juli 1976,**
**New York, US,**

(73) Patentinhaber International Business Machines
Corporation, Armonk, N.Y. 10504 (US)

(72) Erfinder **Dykeman, Robert Horton, 13 Spackenkill Road,**
**Poughkeepsie, NY 12602 (US)**
Erfinder **Wong, Man-Chong, 16 Jackson Drive,**
**Poughkeepsie, NY 12603 (US)**

(74) Vertreter **Gaugel, Heinz, Dipl.-Ing., Schönaicher**
**Strasse 220, D-7030 Böblingen (DE)**

**H. M. GARTNER: »Compensation mechanism for**
**uniform sputtering«,**
**Seiten 516—517**
**SOLID STATE TECHNOLOGY, Vol. 18,**
**Nr. 12, Dezember 1975,**
**T. C. TISONE: »Low voltage triode sputtering**
**with a confined plasma«,**
**Seiten 34—39**

Vorrichtung zur Beschichtung von Werkstücken durch Kathodenzerstäuben

Die Erfindung geht aus von einer bekannten Vorrichtung zur Beschichtung von Werkstücken durch Kathodenzerstäuben (US-A-3 661 761), durch welche mit Hilfe einer Anordnung von Ausnehmungen in der Anodenplatte eine größere Gleichmäßigkeit der Schichtdicke eines zu beschichtenden Werkstücks erreicht werden soll. In dieser Weise kann die Zerstäubungsintensität in vorgegebenen Flächenbereichen geändert bzw. ausgeglichen werden. Die bekannte Vorrichtung hat den Nachteil, daß die Anode der Zerstäubungsvorrichtung eine vorgegebene Struktur aufweist, die nicht an verschiedene Werkstückformen angepaßt werden kann.

Es ist ferner bekannt (IBM Technical Disclosure Bulletin, Volume 19, Nr. 2, Seiten 516 bis 517, Juli 1976), eine Vorrichtung zur Beschichtung von Werkstücken durch Kathodenzerstäuben so auszubilden, daß die Werkstücke auf einer Trägerplatte aus Quarz unterschiedlich weit von der Kathode entfernt sind, wenn die Trägerplatte auf der Anode der Zerstäubungsvorrichtung aufgelegt ist. Durch diese Vorrichtung kann eine ausreichende Gleichmäßigkeit der Schichtdicke der verschiedenen Werkstücke nicht erreicht werden, da die verschiedenen Abstände der einzelnen Werkstücke von der Kathode für den ganzen Oberflächenbereich eines Werkstücks konstant sind, so daß sich innerhalb einer Werkstückoberfläche Ungleichmäßigkeiten ergeben können.

Aus Solid State Technology, Vol 18, Nr. 12, Dezember 1975, T. C. Tisone »Low voltage triode sputtering with a confined plasma«, Seiten 34 – 39, ist bekannt, daß die Ungleichmäßigkeiten abnehmen, wenn die Entfernung zur Kathode zunimmt. Da mit zunehmender Entfernung jedoch auch die Aufdampfrate abnimmt, werden gemäß dieser Literaturstelle die Wafer konzentrisch leicht geneigt angeordnet.

Es ist die Aufgabe der vorliegenden Erfindung, eine Vorrichtung zur Beschichtung von Werkstücken durch Kathodenzerstäuben so auszubilden, daß alle Werkstücke, an denen ein Beschichtungsvorgang gleichzeitig durchgeführt wird, eine gleichmäßige Dicke der Beschichtung erhalten. Diese Aufgabe wird bei einer Vorrichtung nach dem Oberbegriff des Anspruchs 1 durch die in dessen Kennzeichen genannten Merkmale gelöst. Die Lösungsmerkmale bewirken ein höheres Potential im äußeren Bereich der kreisförmigen Musteranordnung der Wafer, so daß sich in den entsprechenden Randbereichen der Wafer eine höhere Schichtdicke ergibt.

Die Erfindung wird anhand von Abbildungen näher erläutert.

Es zeigt

Fig. 1 eine Seitenansicht der Gesamtanordnung der Vorrichtung zur Beschichtung von Werkstücken durch Kathodenzerstäuben,

Fig. 2A die Obenansicht einer bekannten Anordnung von Wafern in einer Vorrichtung zur Beschichtung durch Kathodenzerstäuben,

Fig. 2B einen Querschnitt entlang der in Fig. 2A gezeigten Schnittlinie 2B-2B,

Fig. 3 Diagramme der Schichtdicke, die durch die bekannte, gemäß der Fig. 2A und 2B dargestellten Vorrichtung erzielt wird,

Fig. 4A die Obenansicht einer gemäß der vorliegenden Erfindung ausgebildeten Vorrichtung zur Beschichtung von Wafern durch Kathodenzerstäuben,

Fig. 4B einen Querschnitt der in Fig. 4A dargestellten Vorrichtung entlang der Schnittlinie 4B-4B,

Fig. 5 die Diagramme von Kenngrößen der Schichtdicke, die durch die bekannte Vorrichtung und durch die Vorrichtung gemäß der Erfindung erzielt werden,

Fig. 6A die Obenansicht einer anderen Ausführungsform der Vorrichtung gemäß der vorliegenden Erfindung,

Fig. 6B einen Querschnitt der in Fig. 6A gezeigten Vorrichtung entlang der Schnittlinie 6B-6B,

Fig. 7 Diagramme der Schichtdicke, die durch eine Vorrichtung gemäß den Darstellungen nach den Fig. 6A und 6B erzielt wird,

Fig. 8 die Obenansicht einer anderen Ausführungsform der Vorrichtung gemäß der vorliegenden Erfindung,

Fig. 9 Diagramme der Schichtdicke, die durch eine Vorrichtung gemäß der Darstellung nach Fig. 8 erzielt wird.

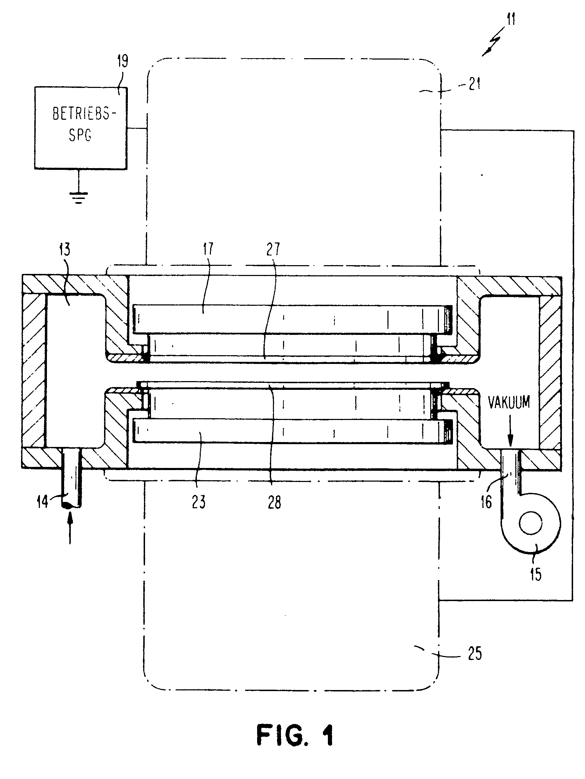

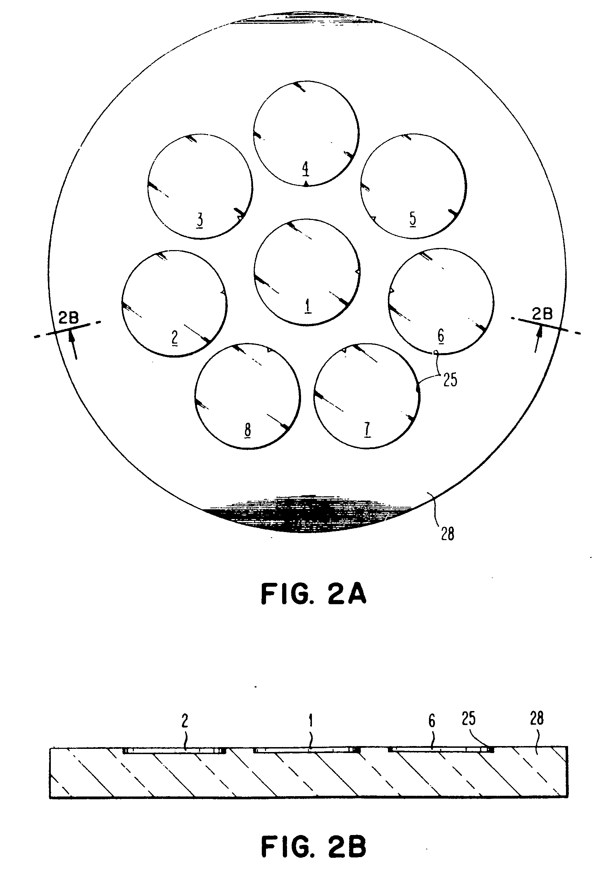

Die in Fig. 1 gezeigte Vorrichtung zur Beschichtung von Werkstücken durch Kathodenzerstäuben enthält eine Entladungskammer 13 und eine Vakuumpumpe 15, durch welche der in der Entladungskammer bestehende Druck über die Leitung 16 abgesenkt wird. Durch die Leitung 14 wird in die Entladungskammer 13 ein ionisierbares Gas, wie z. B. Argon oder Neon, eingeleitet. Die Kathode 17 ist über die Übertragungseinheit 21 mit der Betriebsspannung 19 verbunden. Die Betriebsspannung 19 wird ferner der Anode 23 durch die Übertragungseinheit 25 zugeleitet. Die Kathode 17 trägt eine Schicht 27, die durch das zu zerstäubende Material, wie z. B. Quarz oder Silikonnitrid, gebildet wird. Die durch Kathodenzerstäubung zu beschichtenden Werkstücke werden an der Anode 23 aufgelegt. Wie aus den Fig. 2A und 2B hervorgeht, werden in bekannter Weise kreisförmig ausgebildete Wafer 1 – 8 in Vertiefungen 25 einer aus Quarzmaterial bestehende Trägerplatte 28 eingelegt, die an der Anode einer Vorrichtung für das Kathodenzerstäuber angeordnet wird

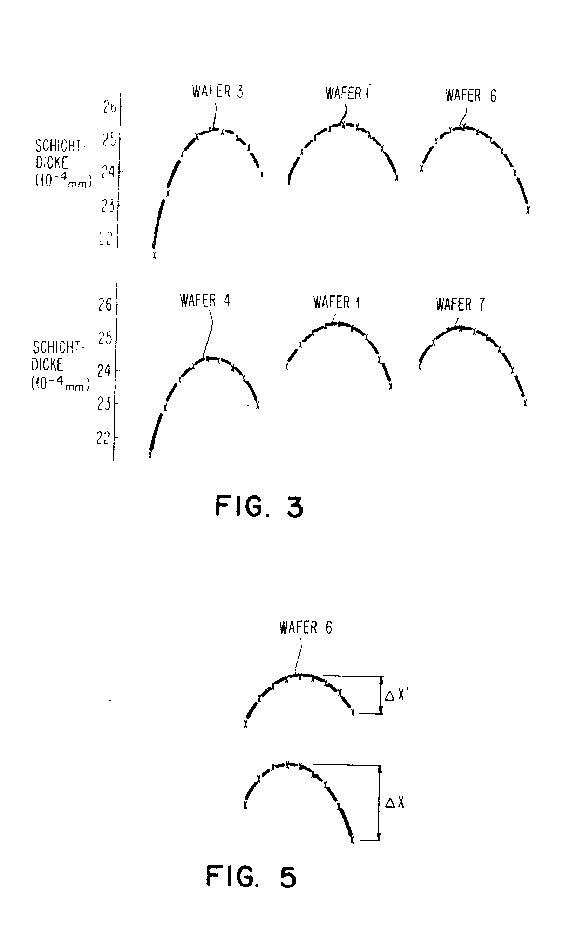

Die Fig. 3 dargestellten Diagramme zeigen, die entlang von zwei verschiedenen Durchmessern der Trägerplatte 28 gemessene Schichtdicke der Wafer 3, 1, 0 bzw. 4, 1, 7. Daraus geht hervor, daß die Wafer 3, 6, 4 und 7, die am Rand der in 2A

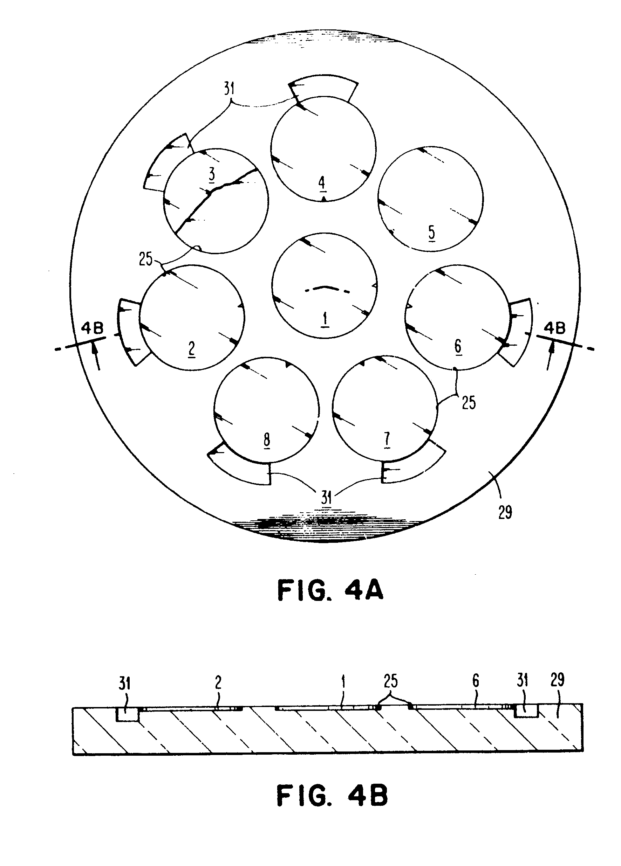

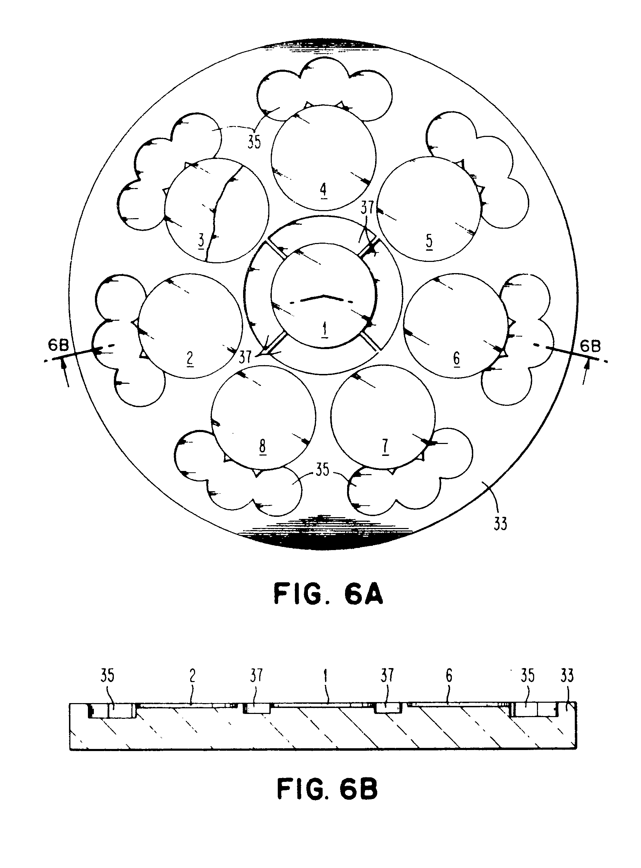

gezeigten konzentrischen Musteranordnung liegen, in ihren Randbereichen am Umfang des konzentrischen Musters einen größeren Abfall der Schichtdicke aufweisen als das Wafer 1, das im Zentrum des konzentrischen Musters angeordnet ist. Die relative Dickenänderung $\Delta X$, deren Verlauf in Fig. 5 dargestellt ist, ergibt sich aus dem Verhältnis der einzelnen Meßwerte der Dicke entlang eines Durchmessers. Aus der Tabelle I ergeben sich die Werte der relativen Dickenänderung $\Delta X$ für die durch die Fig. 2A dargestellte bekannte Vorrichtung zur Beschichtung von Wafern und die Werte $\Delta X'$, wie sie anhand der in Fig. 4A dargestellten Vorrichtung zur Beschichtung von Wafern beschrieben werden.

Die anhand der Fig. 4A und 4B erläuterte Vorrichtung für die Beschichtung von Werkstükken durch Kathodenzerstäuben zeigt, daß die aus Quarz bestehende Trägerplatte 29, durch welche die Wafer 1–8 an der Anode der Entladungskammer aufgelegt werden, Vertiefungen 25 für das Einlegen der Wafer enthält, die in Teilbereichen eines Waferumfangs über den Rand eines Wafers hinausgehend in radialer Richtung sich erstreckende Vertiefungserweiterungen 31 aufweisen. Diese haben die geometrische Form von Sektoren eines Kreisringes. Die Seitenbegrenzungen dieser Vertiefungen 31 können entweder senkrecht oder schräg verlaufen. Im vorliegenden Ausführungsbeispiel beträgt der Sektorwinkel eines Kreisringsektors 60° und dessen Tiefe beträgt zwischen 0,5 mm – 1,5 mm. Wie aus der in Fig. 5 dargestellten Tabelle I hervorgeht, werden die Werte der relativen Dickenänderungen $\Delta X'$ durch eine Vorrichtung gemäß der Fig. 4A um 40% gegenüber den Werten der relativen Dickenänderung $\Delta X$ ermäßigt, die durch eine Vorrichtung gemäß der Fig. 2A erzielt werden.

Tabelle I

| Wafer | $\Delta X$ | $\Delta X'$ |
|---|---|---|
| 2 | 15,1% | 7,7% |
| 3 | 11,9% | 8,1% |
| 4 | 11,7% | 6,8% |
| 6 | 8,0% | 4,5% |
| 7 | 9,7% | 5,4% |
| 8 | 8,2% | 6,3% |

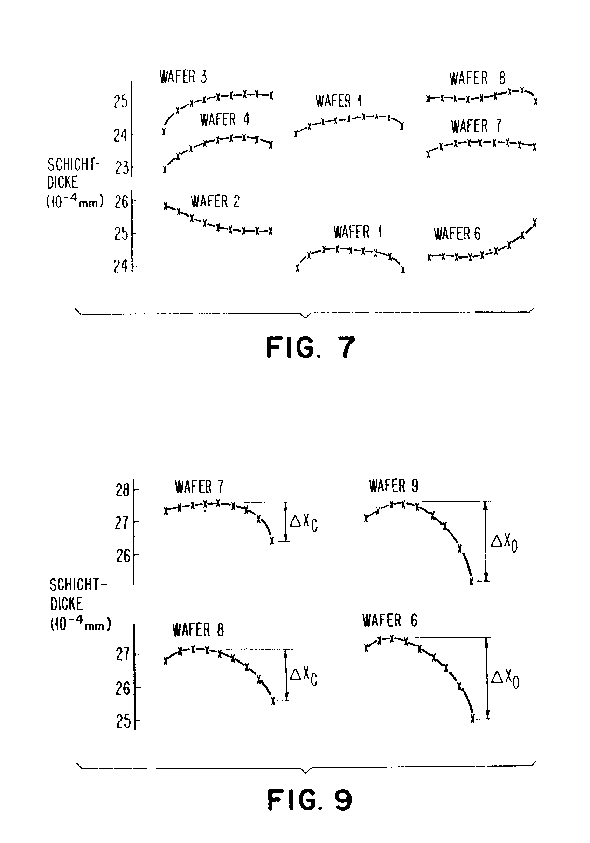

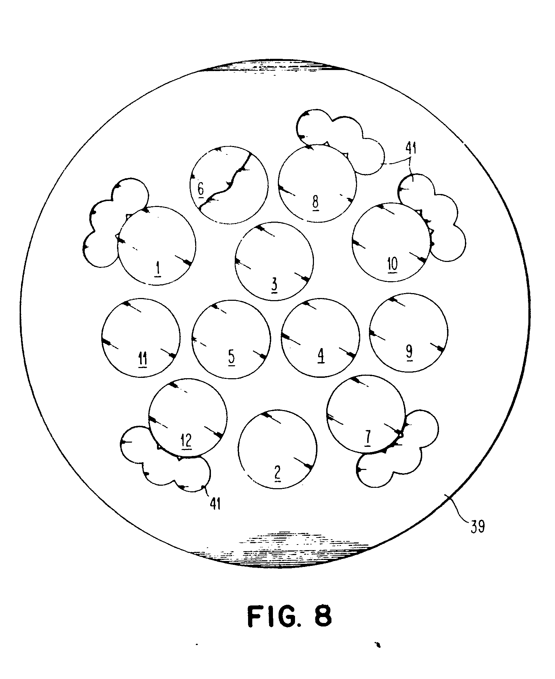

Das Ausführungsbeispiel einer Vorrichtung zur Beschichtung von Werkstücken durch Kathodenzerstäuben zeigt die Fig. 6A, bei welcher die Trägerplatte 33 aus Quarzmaterial größere Vertiefungserweiterungen 35 aufweist. Die geometrische Form dieser Vertiefungserweiterungen ergibt sich aus der Zusammensetzung von gegenseitig sich überschneidenden Kreisflächen. Ihre Tiefe beträgt 0,5 bis 1,5 mm und der Durchmesser eines der sich überlappenden Kreise beträgt ungefähr 3 cm. Die entlang von verschiedenen Durchmessern der Trägerplatte 33 gemessene Schichtdicke der Wafer 3, 1, 7 bzw. 4, 1, 8 bzw. 2, 1, 6 ergibt sich aus Fig. 7. Die Vertiefungserweiterungen 37 am Umfang des Wafers 1 haben die geometrische Form der Sektoren von Kreisringen, mit einer Tiefe von 1 mm und einer Breite von annähernd 10 mm. Durch die anhand der Fig. 6A dargestellten Vorrichtung ergeben sich Meßwerte der relativen Dickenänderung $\Delta X'$, die bezüglich der relativen Dickenänderungen $\Delta X$ der bekannten Vorrichtung erheblich ermäßigt sind, wie dies aus der Tabelle II hervorgeht

Tabelle II

| Wafer | $\Delta X$ | $\Delta X'$ |
|---|---|---|
| 1 | 6,9% | 2,7% |
| 2 | 15,1% | 3,3% |
| 3 | 11,9% | 4,3% |
| 4 | 11,7% | 4,2% |
| 5 | 8,1% | 3,8% |
| 6 | 8,5% | 4,5% |
| 7 | 9,3% | 0,4% |
| 8 | 7,7% | 0,9% |

Das in Fig. 8 gezeigte weitere Ausführungsbeispiel einer Vorrichtung zur Beschichtung von Werkstücken durch Kathodenzerstäuben besteht aus einer Trägerplatte 39, die eine Dicke von ungefähr 6 mm aufweist. Die Durchmesser der Wafer 1–10 betragen ungefähr 8 cm, und die Vertiefungen, in welche die Wafer eingefügt sind, haben eine Tiefe von ungefähr 0,35 mm. Die Vertiefungserweiterungen, die an vorgegebenen Stellen der Vorrichtung angeordnet sind, haben verschiedene Tiefen von z. B. 1 mm und 1,5 mm.

Fig. 9 zeigt Meßwerte $\Delta X_C$ der Schichtdicke für die Wafer 7 und 8, denen gemäß der Darstellung nach Fig. 8 Vertiefungserweiterungen 41 zugeordnet sind. Die Meßwerte $\Delta X_0$ der Schichtdicke für die Wafer 6 und 9 zeigen eine größere Änderung der Schichtdicke in den Randbereichen der Wafer.

Aus den beschriebenen Ausführungsbeispielen geht hervor, daß die Vertiefungserweiterungen einer Vorrichtung den Zweck haben, in den Randbereichen der Wafer eine größere Schichtdicke zu erzielen. In dieser Weise wird bei einem Beschichtungsvorgang von Wafern eine gleiche Schichtdicke der verschiedenen behandelten Wafer erzielt, so daß im nachfolgenden Prozeß bei gleicher Ätzgeschwindigkeit für alle Wafer, unabhängig davon, ob sie beim Beschichtungsvorgang in der Mitte oder am Rand des konzentrischen Anordnungsmusters an der Trägerplatte angeordnet waren, gleichbleibende Herstellungsqualität aufweisen.

Die bei den verschiedenen Vorrichtungen verwendeten Vertiefungserweiterungen der Trägerplatte haben offenbar zur Folge, daß die in verschiedenen Bereichen zwischen der Kathode und der Anode der Entladungskammer sich ergebenden Potentialdifferenzen ausgeglichen werden. Der Ausgleich ergibt sich durch die erzielten Formänderungen der Trägerplatte, die zwischen den Elektroden der Entladungskammer ein Dielektrikum bildet.

## Patentansprüche

1. Vorrichtung mit einer Trägerplatte zur Beschichtung von Werkstücken durch Kathodenzerstäuben, insbesondere von als kreisförmigen Wafer ausgebildeten Halbleiterstrukturen, die durch Anordnung in Vertiefungen einer Trägerplatte aus Quarz mit regelmäßigen gegenseitigen Abständen in Form eines konzentrischen Musters an der Oberfläche der Anodenplatte einer Entladungskammer auflegbar sind, dadurch gekennzeichnet, daß die Vertiefungen der Trägerplatte (29, 33) in Teilbereichen eines Waferumfangs über den Rand eines Wafers hinausgehend in radialer Richtung sich erstreckende Vertiefungserweiterungen (31, 35, 37, 41) aufweisen.

2. Vorrichtung nach Anspruch 1, dadurch gekennzeichnet, daß die Vertiefungserweiterungen (31, 35, 37, 41) tiefer in die Trägerplatte (29, 33 39) eingefügt sind als die Auflagenflächen der Wafer (1 8)

3. Vorrichtung nach Anspruch 1 oder 2, dadurch gekennzeichnet, daß am Rand des konzentrischen Anordnungsmusters aufgelegte Wafer (2 8) Vertiefungserweiterungen (31, 35, 41) in Bereichen der Umfangslinie des Anordnungsmusters aufweisen.

4. Vorrichtung nach einem der Ansprüche 1 bis 3, dadurch gekennzeichnet, daß die Vertiefungserweiterungen (31, 37) als Sektoren von Kreisringen geformt sind.

5. Vorrichtung nach einem der Ansprüche 1 bis 4, dadurch gekennzeichnet, daß die Form der Vertiefungserweiterungen (35, 41) aus gegenseitig sich überschneidenden Kreisflächen zusammengesetzt ist.

## Claims

1. System with an anode plate for coating workpieces by cathode sputtering, in particular semiconductor structures designed as circular wafers, which by being placed in pockets of a quartz anode plate can be applied at regular mutual spacings in the form of a concentric pattern to the surface of the anode plate of a discharge chamber, characterized in that the pockets of the anode plate (29, 33) in partial areas of a wafer circumference have cutouts (31, 35, 37, 41) extending beyond the edge of a wafer in a radial direction

2. System in accordance with claim 1, characterized in that the cutouts (31, 35, 37, 41) are recessed more deeply in the anode plate (29, 33, 39) than the supporting faces of the wafers (1 8)

3. System in accordance with claim 1 or 2, characterized in that wafers (2 – 8) applied along the edge of the concentric pattern of arrangement have cutouts (31, 35, 41) in regions of the circumferential line of the pattern of arrangement

4. System in accordance with any one of the claims 1 to 3, characterized in that the cutouts (31, 37) are shaped as sectors of circular rings

5. System in accordance with any one of the claims 1 to 4, characterized in that the shape of the cutouts (35, 41) is made up of mutually overlapping circular areas

## Revendications

1. Dispositif muni d'une plaque de support pour déposer, par pulvérisation cathodique, une couche sur des pièces, en particulier des structures semi-conductrices formant des tranches circulaires, qu'on peut appliquer, en les mettant dans les creux d'une plaque de support en quartz ayant des intervalles reguliers et constituant une configuration concentrique, sur la surface de la plaque d'anode d'une chambre a decharge, caracterise en ce que

les creux de la plaque de support (29, 33) dans des regions partielles de la circonference d'une tranche présentent des agrandissements de creux (31, 35, 37, 41) dépassant le bord d'une tranche dans la direction radiale

2. Dispositif selon la revendication 1, caractérisé en ce que les agrandissements de creux (31, 35, 37, 41) sont situés plus profondément dans la plaque de support (29, 33, 39) que les surfaces portantes des tranches (1 à 8)

3. Dispositif selon l'une quelconque des revendications 1 ou 2, caractérisé en ce que.

des tranches (2 à 8) appliquees sur le bord de la condiguration concentrique présentent des agrandissements de creux (31, 35, 41) dans les régions de la ligne de pourtour de la configuration.

4. Dispositif selon l'une des revendications 1 à 3, caractérisé en ce que les agrandissements de creux (31, 37) sont constitues par des secteurs d'anneaux circulaires.

5. Dispositif selon l'une des revendications 1 à 4, caractérisé en ce que la forme des agrandissements de creux (35, 41) est composée de surfaces circulaires se chevauchant mutuellement.

**FIG. 1**

**FIG. 2A**

**FIG. 2B**

FIG. 3

FIG. 5

FIG. 4A

FIG. 4B

**FIG. 6A**

**FIG. 6B**

**FIG. 7**

**FIG. 9**

**FIG. 8**